# EUROPEAN PATENT SPECIFICATION

(11) **EP 1 429 593 B1**
(45) Date of publication and mention of the grant of the patent: **13.02.2008**
(21) Application number: 03028512.6
(22) Date of filing: 10.12.2003
(51) Int. Cl.: H05K 13/08

(54) **Electronic component mounting apparatus**
Einrichtung zur Montage von elektronischen Bauteilen
Dispositif de montage de composants électroniques

(30) Priority: 10.12.2002 JP 2002358150
(43) Date of publication of application: 16.06.2004
(73) Proprietor: Hitachi High-Tech Instruments Co., Ltd., Ora-gun, Gunma-ken, 370-0596 (JP)
(72) Inventor: Kurata, Kenji, Ota-shi, Gunma (JP); Takemura, Iukuo, Ora-gun, Gunma (JP); Iida, Shigeru, Ota-shi, Gunma (JP); Watanabe, Hiroyuki, Yamada-gun, Gunma (JP); Kano, Yoshinori, Yamada-gun, Gunma (JP)
(74) Representative: Glawe, Delfs, Moll

(56) References cited:
- EP-A- 1 032 251
- JP-A- 7 079 094
- JP-A- 11 154 797
- JP-A- 11 204 993
- US-A- 5 661 239

## Description

### BACKGROUND OF THE INVENTION

### Field of the Invention

The invention relates to an electronic component mounting apparatus for picking electronic components up by suction nozzles from component feeding units and mounting the electronic components on a printed board.

### Description of the Related Art

A conventional electronic component mounting apparatus of this type employs a fiber sensor for detecting presence or absence of a suction nozzle. As described in the Japanese Patent Application Publication No. 2001-102799, a standing component detection sensor (line sensor) is used for a correction of a lower end level of the suction nozzle after picking up a component.

However, the fiber sensor, which is used as a detection sensor for detecting presence or absence of the suction nozzle, can not be used for detection of an electronic component mistakenly held by the suction nozzle even after a component mounting operation or for a correction of a lower end level of the suction nozzle (a height of a pickup position) because the suction nozzle wears out with time.

Furthermore, since the standing component detection sensor is used for a correction of the lower end level of the suction nozzle after picking up the component, the correction can not be performed during running of the mounting apparatus so that the mounting apparatus is forced to stop mounting operation.

An electronic component mounting apparatus as disclosed in US-A-5 661 239 comprises a sensor designed for detecting the position of a lower end of a suction nozzle, after the suction nozzle has released the electronic component to be mounted. The sensor is comprised of a thin bendable plate and a proximity sensor. The plate is adjusted so that in normal operation the lower end of the suction nozzle just passes over its upper edge. If the suction nozzle is projecting excessively downwards, the plate will be contacted and bent, moving it away from the proximity sensor, thereby allowing detection of the excessively downward projecting state of the suction nozzle. Although this mounting apparatus is capable of detecting an electronic component mistakenly held by the suction nozzle even after a component mounting operation, it is not capable of obviating the other errors as stated above.

The object of this invention is to provide an electronic component mounting apparatus that serves to lessen these drawbacks.

### SUMMARY OF THE INVENTION

The solution according to the invention lies in the features of the independent claims and preferably in those of the dependent claims.

The invention provides an electronic component mounting apparatus that includes a component feeding unit feeding an electronic component, a suction nozzle picking up the electronic component from the component feeding unit and mounting the electronic component on a printed board, and a sensor detecting a vertical position of a lower end of the suction nozzle after the suction nozzle releases the electronic component to the printed board, wherein the sensor is a position sensor for measuring a vertical position of the lower end of the suction nozzle, and further comprising a decision device judging that the suction nozzle is missing when the vertical position of the lower end of the suction nozzle measured by the position sensor is higher than a predetermined position.

The invention also provides an electronic component mounting apparatus that includes a plurality of component feeding units feeding electronic components, a plurality of suction nozzles provided on a mounting head for picking up the electronic components from the component feeding units and mounting the electronic components on a printed board, and a line sensor unit comprising a first light source and a light receiving device. The line sensor is configured to measure a vertical position of a lower end of each of the suction nozzles after the suction nozzles release the electronic components to the printed board. The apparatus also includes a second light source provided in the line sensor unit in addition to the first light source, and a decision device judging that a suction nozzle is about to fall when the amount of light received by the light receiving device from the first and second light sources is below a predetermined amount.

The invention achieves to ensure correct operation of the mounting apparatus, even if the suction nozzle is missing or changes its length, e. g. if it is worn with time or changes its lower end level by thermal expansion. The position sensor according to the invention allows even in this case to properly pick up and mount the electronic component by controlling a descending amount of the suction nozzle corresponding to its changed length.

### BRIEF DESCRIPTION OF THE DRAWINGS

Fig. 1 is a schematic plan view of an electronic component mounting apparatus of a first embodiment of this invention.
Fig. 2 is a partially cutaway side view of the electronic component mounting apparatus of Fig. 1.
Fig. 3 is an schematic perspective view of an electronic component feeding unit of the electronic component mounting apparatus of Fig. 1.
Fig. 4 is a front view of a vertical shifting mechanism of a mounting head of the electronic component mounting apparatus of Fig. 1.
Fig. 5 is another front view of the vertical shifting mechanism of the mounting head of the electronic component mounting apparatus of Fig. 1.
Fig. 6 is a side view of the vertical shifting mechanism of the mounting head of Fig. 4.
Fig. 7 is a block diagram of the electronic component mounting apparatus of Fig. 1.
Fig. 8 is a table of a component library data of the electronic component mounting apparatus of Fig. 1.
Fig. 9 is a view showing an operation of a line sensor unit of the electronic component mounting apparatus of Fig. 1.
Fig. 10 is a cross-sectional view of the line sensor unit of a electronic component mounting apparatus of a second embodiment of this invention.
Fig. 11 is a cross-sectional view of the line sensor unit of Fig. 10 with schematic movements of suction nozzles.

### DETAILED DESCRIPTION OF THE INVENTION

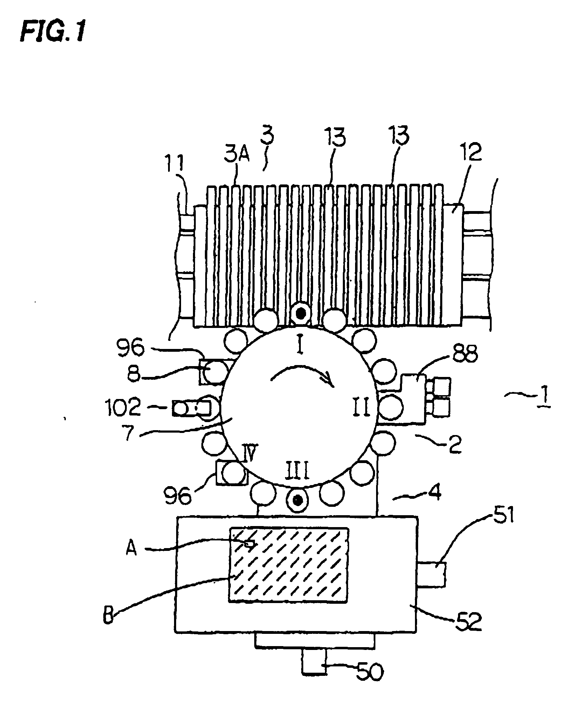

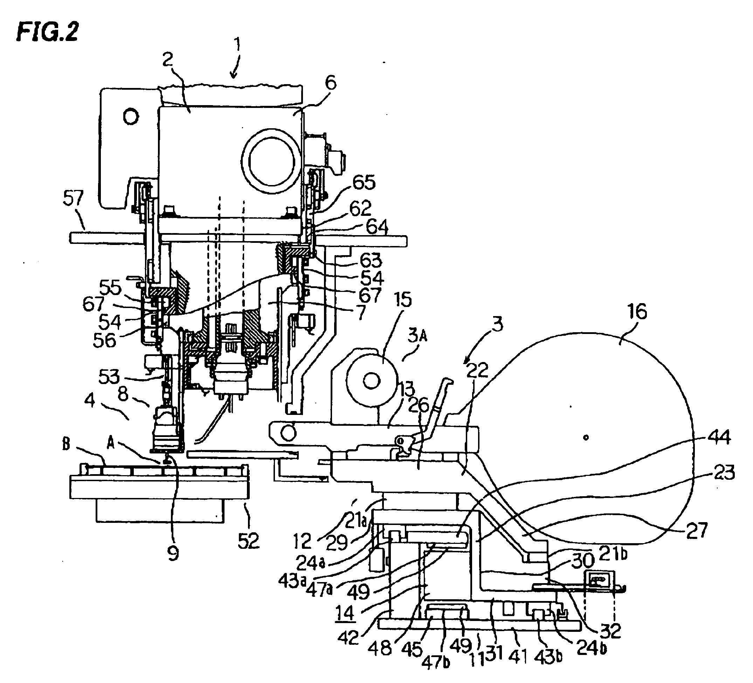

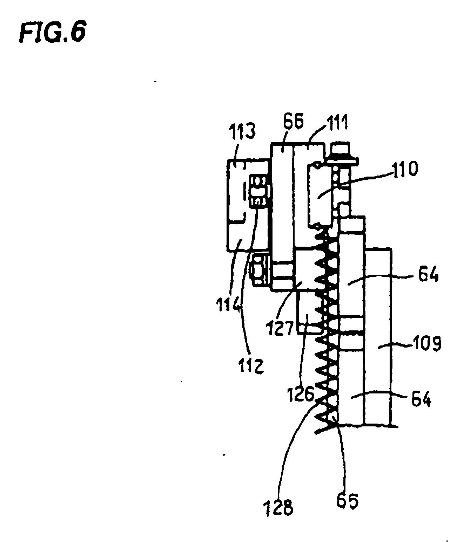

An electronic component mounting apparatus of a first embodiment of the invention will be described with reference to Figs. 1-9. As shown in Figs. 1 and 2, in an electronic component mounting apparatus of high-speed type 1, a feeding system 3 for feeding electronic components A and a mounting system 4 for mounting the electronic components A on a printed board B are disposed in parallel with each other with a main body 2 interposed therebetween. The feeding system 3 includes an electronic component feeding device 3A.

The main body 2 has an index unit 6 as a main body of a drive system, a rotation table 7 connected to the index unit 6, and a plurality (for example, twelve) of mounting heads 8 mounted on an outer circumference of the rotation table 7. The rotation table 7 intermittently rotates by a predetermined pitch corresponding to the number of the mounting heads 8 each provided with a plurality of suction nozzles 9, driven by the index unit 6. By intermittent rotation of the rotation table 7, any one of the suction nozzles 9 mounted on each of the mounting heads 8 moves to the feeding system 3 or the mounting system 4 as appropriate. That is, the suction nozzle 9 moves to the feeding system 3 in order to pick up the electronic component A fed by the feeding system 3, and then moves by rotating to the mounting system 4 in order to mount the electronic component A on the printed board B conveyed to the mounting system 4.

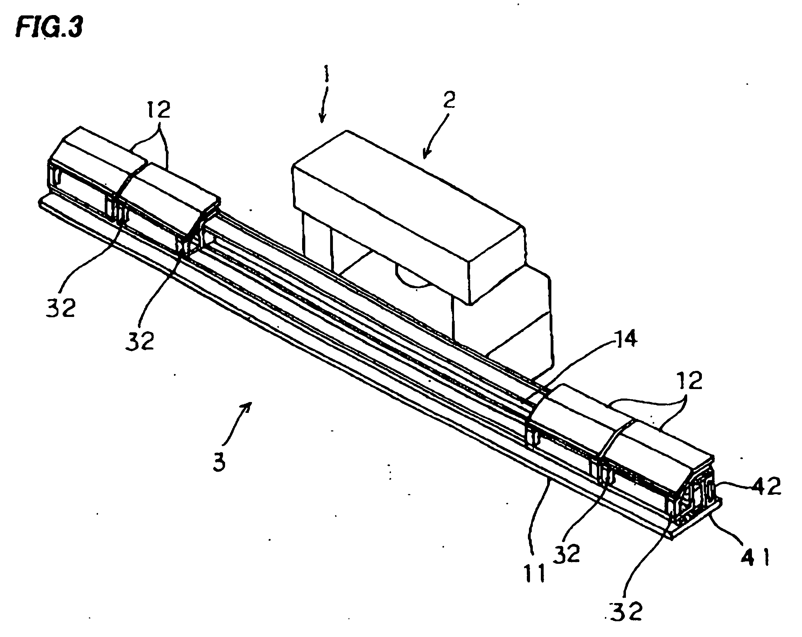

As shown in Fig. 3, the electronic component feeding device 3A of the feeding system 3 has a base 11 extending in a lateral direction, four slide bases (unit bases) 12 slidably mounted on the base 11, many component feeding units 13 attachably mounted on each of the slide bases 12, and a linear motor 14 provided between the base 11 and the slide bases 12. Two pairs of the slide bases 12 are each disposed on left and right sides of the base 11. Two groups of the component feeding units 13 are alternately moves to the main body 2 by each of the two pairs of the slide bases 12. That is, while one pair of slide bases 12 on one side, which has the component feeding units 13 thereon, slides to a front of the main body 2 to feed the electronic components A, another pair of slide bases 12 at an original position on another side performs a replacement operation of the component feeding units 13 for a next feeding operation.

The component feeding units 13 are formed thin, and aligned in a lateral direction at narrow intervals on the slide bases 12. Each of these component feeding units 13 is positioned on the slide base 12 and mounted thereon being attachable by a lever. Each of the mounting heads 8 (suction nozzles 9) of the main body 2 moves to each end of the component feeding units 13 mounted on the slide bases 12 to pick the electronic component A up by suction. In each of the component feeding units 13, a carrier tape having the electronic components A therein at predetermined pitches is wound around a tape reel 16. Each of the electronic components A stored in the carrier tape is exposed by peeling a cover tape off the carrier tape fed from the tape reel 16 (the cover tape winding around a cover tape reel 15) and is picked up by the suction nozzle 9.

The slide base 12 has a base block 22 on an upper side and a slide block 23 on a lower side, which are positioned and fixed by left and right connecting members 21a and 21b. The component feeding units 13 are mounted on an upper surface of the base block 22, and a pair of left and right sliders 24a and 24b is provided on a lower surface of the slide block 23. The base block 22 includes a horizontal portion 26 and a sloped portion 27. The horizontal portion 26 has the component feeding units 13 mounted thereon and the sloped portion 27 is located keeping off the tape reel 16.

The slide block 23 includes an upper horizontal portion 29, a vertical portion 30, and a lower horizontal portion 31, and is formed into a crank shape in its cross-section. A plurality of ribs 32, which is formed by cutting in order to form a radiating fin, is provided on an outer side of the vertical portion 30 to the lower horizontal portion 31. The upper horizontal portion 29 supports the horizontal portion 26 of the base block 22 through one connecting member 21a, and the ribs 32 supports the sloped portion 27 of the base block 22 through other connecting member 21b. The first slider 24a is fixed on a lower surface of an outer end of the upper horizontal portion 29, and the second slider 24b is fixed on a lower surface of an outer end of the lower horizontal portion 31.

The base 11 includes a base body 41 and a vertical block 42. A first slide rail 43a engaged with the first slider 24a is attached on an upper end surface of the vertical block 42, and a second slide rail 43b engaged with the second slider 24b is attached on an upper end surface of the base body 41. An upper magnet base 44 is attached to an upper surface of the vertical block 42, extending in a horizontal direction. A lower magnet base 45 is attached to an upper surface of the base body 41, facing toward the upper magnet base 44.

The linear motor 14 has a pair of upper and lower stationary members 47a and 47b fixed on the base 11, and a moving member 48 fixed on the slide base 12. The stationary members 47a and 47b include the upper and lower magnet bases 44 and 45, and upper and lower magnets 49. The upper magnets 49 are fixed on a lower surface of the upper magnet base 44 downward, and the lower magnets 49 are fixed on an upper surface of the lower magnet base 45 upward. The moving member 48 has substantially the same length as that of the slide base 12, and fixed on a side of the vertical portion 30 of the slide block 23. An upper surface and a lower surface of the moving member 48 face the upper stationary member 47a and the lower stationary member 47b respectively with gaps (air gaps) therebetween. That is, the moving member 48 and each of the upper and lower stationary members 47a and 47b face each other, to operate as the linear motor 14 as a whole.

The moving member 48 fixed on the slide block 23 is formed by winding an exciting coil around a magnetic core (not shown), while the upper and lower stationary members 47a and 47b are formed by aligning many magnets 49 in a longitudinal direction on the upper and lower magnet bases 44 and 45.

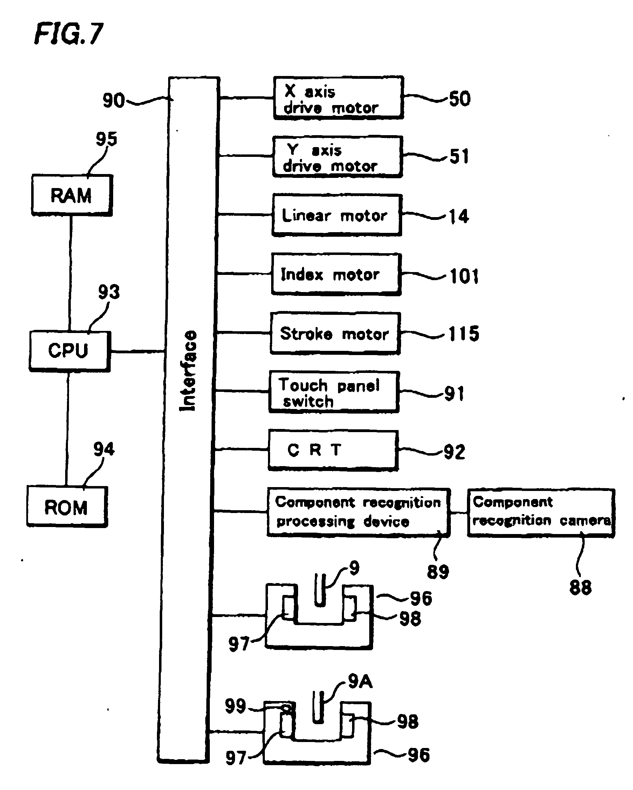

The printed board B is fixed on an XY table 52 which is movable in the X and Y directions driven by an X axis drive motor 50 and a Y axis drive motor 51 shown in Figs. 1 and 7, and receives the component A from the suction nozzle 9 at the mounting station III.

Each of the mounting heads 8 is attached to a lower portion of a head vertical shifting shaft 53. The head vertical shifting shaft 53 is fixed on a roller attached body 54 on its upper portion. The upper and lower cam followers 55 and 56 are rotatably attached to an upper portion of the roller attached body 54, protruding inside the roller attached body 54.

A numeral 57 designates a support for rotatably supporting the rotation table 7 in a horizontal direction from above. A cylindrical cam is fixed protruding on the support 57 around a rotation axis of the rotation table 7 supported by the support 57. The cam follower 55 contacts an upper surface of the cylindrical cam to suspend the roller attached body 54, thereby supporting the mounting head 8. The lower cam follower 56 pushes a lower surface of the cylindrical cam, being pulled by a compression spring (not shown).

Accordingly, the cylindrical cam is interposed between the cam followers 55 and 56. By rotation of the rotation table 7, the cam followers 55 and 56 move rotating on the upper and lower surfaces of the cylindrical cam. Since the cylindrical cam moves upward and downward, the mounting head 8 moves with rotating and moving upward and downward.

A numeral 63 is a vertical shift block formed into a horseshoe shape at its cross section. The vertical shift block 63 is disposed in a cut-off portion of the cylindrical cam at the pickup station I. An upper end of the vertical shift block 63 is attached to a vertical shift board 65 which is vertically movable along a guide 64 attached on the support board 62.

A protrusion 67 at a lower portion of the vertical shift block 63 is placed at a position extending from the cylindrical cam when the vertical shift block 63 rises. Therefore, by rotation of the rotation table 7, the cam followers 55 and 56 shift to positions on and under the protrusion 67 respectively, the protrusion 67 being interposed between the cam followers 55 and 56.

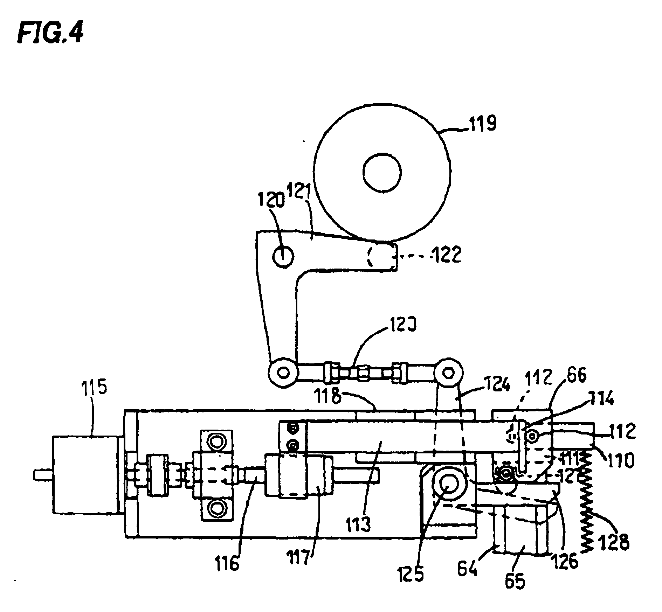

As shown in Figs. 4 to 6, a rail 110 is attached to an upper end of the vertical shift board 65, and a guide 111 is provided movable in a horizontal direction along the rail 110, so that a moving body 66 can move in vertical and horizontal directions along the guide 111. A pair of rollers 112 is rotatably attached to a front surface of the moving body 66. A vertical guide piece 114 is formed on the stroke adjustable plate 113, being interposed between the rollers 112. Therefore, the moving body 66 vertically moves along the guide piece 114. By this movement, the rail 110 and the vertical shift board 65 move vertically.

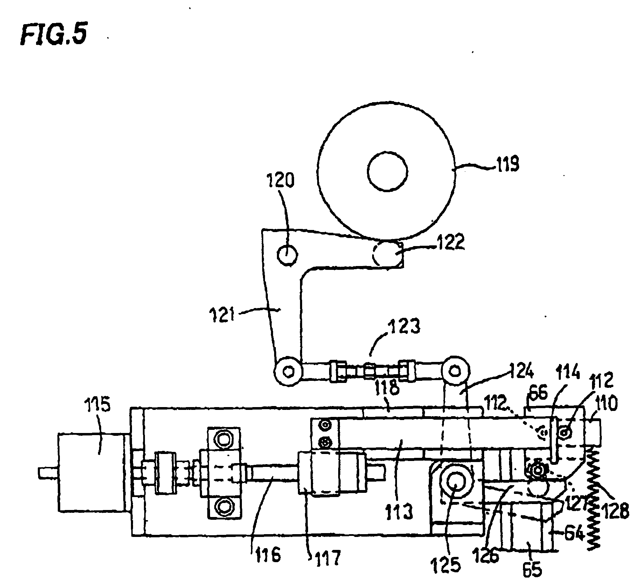

A numeral 115 designates a stroke motor for rotating a ball screw 116 engaged with a nut 117 to move the stroke adjustable plate 113 attached to the nut 117 along a guide 118 in a lateral direction. By movement of the stroke adjustable plate 113, the moving body 66 moves along the rail 110 through the rollers 112 interposing the guide piece 114 therebetween to positions as shown in Figs. 4 and 5.

A numeral 119 designates a cam for turning a cam lever 121, being engaged with a cam follower 122 pivotally supported on one end of the cam lever 121 which is rotatable around an axis 120. When the cam 119 rotates to turn the cam lever 121, a vertical turning lever 124 which is rotatably supported on one end of a link lever 123 turns around an axis 125 through the link lever 123 which is rotatably supported on another end of the lever 121.

An engagement piece 126 formed in the vertical turning lever 124 is engaged with a cam follower 127 rotatably attached to a back surface of the moving body 66, the cam follower 127 being pulled by a pulling spring 128 stretched between the rail 110 and the support 57. Therefore, the moving body 66 moves vertically along the guide piece 114 by turning of the turning lever 124, the guide 114 being positioned by moving in a lateral direction by rotation of the stroke motor 115.

By rotation of the cam 119, the engagement piece 126 turns between a position drawn by a solid line and a position drawn by a chain line shown in Figs. 4 and 5. A surface of the engagement piece 126 which is engaged with the cam follower 127 is horizontal at the position drawn by a solid line which is at a top in a turning range. At this position drawn by a solid line, the moving body 66, i.e., the vertical shift block 63, does not change at its height at any position which the guide piece 114 moves to by rotation of the stroke motor 115. Therefore, the cam followers 55 and 56 can shift between the cylindrical cam and the vertical shift block 63. At the position drawn by a dotted line where the surface of the engagement piece 126 slants to a right side in Figs. 4 and 5, a lowest position of the moving body 66, i.e., the vertical shift block 63, changes depending on a position of the guide piece 114 which moves in a lateral direction, so that an amount of a vertical stroke of the suction nozzle 9 changes.

A lowest position of the engagement piece 126 is the same any time at a position drawn by a chain line of Figs. 4 and 5, and a surface of the engagement piece 126 which the cam follower 127 contacts has a linear surface. Therefore, an amount of a descending stroke of the moving body 66 generated by a turn of the engagement piece 126 with the cam follower 127 placed at a certain position increases by movement of the moving body 66 in a lateral direction by rotation of the stroke motor 115, proportionally to a lateral moving distance of the moving body 66. This facilitates a control of a vertical stroke of the suction nozzle 9.

The rotation of the cam 119 makes the vertical shift block 63 keep the mounting head 8 at a high position until the mounting head 8 reaches the pickup station I from a previous station, descend the mounting head 8 at the pickup station I, and raise the mounting head 8 when the rotation table 7 starts rotating again. The same structure as above is provided in the mounting station III.

Next, a block diagram of a control in Fig. 7 will be described. A numeral 90 designates an interface which is connected with an index motor 101 for intermittently rotating the X axis drive motor 50, the Y axis drive motor 51, the linear motor 14, and the rotation table 7, a stroke motor 115, a touch panel switch 91, a CRT 92, a component recognition processing device 89, and so on. These are controlled by a CPU 93, which serves as a control device for totally controlling a mounting operation, according to mounting programs stored in a ROM 94.

The touch panel switch 91 is attached to a screen of the CRT 92 using fixtures (not shown). The touch panel switch 91 is made of a glass substrate which is coated with a transparent conductive film on its whole surface and printed with electrodes on its four edges. When an operator touches the surface of the touch panel switch 91 in a state where minimal electric currents flow on the surface of the touch panel switch 91, current flows change at the four electrodes and coordinates of a touched position are calculated by a circuit board connected with the electrodes. If the calculated coordinates correspond to one of coordinates originally stored in the RAM 95 as a switch for executing a certain operation, the operation is executed.

The component recognition processing device 89 takes an image of a lower surface of a component A within a predetermined visual field by a component recognition camera 88, and performs recognition processing of the taken image to recognize a position of the component A in order to detect a shift amount of the component A attached to the suction nozzle 9 from a proper position.

A first measuring station IV at a second position from the mounting station III is provided with a line sensor unit 96, which is formed into a horseshoe shape at its cross section, as a level detection sensor for measuring a level of a lower portion of the suction nozzle 9. The line sensor unit 96 has a floodlight 97 (on one side wall) for emitting light beams in a horizontal direction, and a light receiving device 98 (on another facing side wall) for receiving the emitted light beams, which is formed of many CCD elements linearly aligned in a perpendicular direction. The floodlight 97 can emit parallel light beams by a lens condensing lights from LEDs, or by a laser. In the light receiving device 98, for example, there are aligned about one-thousand CCD elements vertically in a vertical width of 10 mm. Each of the CCD elements can detect an amount of received lights so that each can be used as an ON/OFF sensor by setting a threshold value in a received light amount. By ON or OFF outputs, a portion shaded by the electronic component A or the suction nozzle 9 can be detected so that a level of a lower end of the electronic component A or the suction nozzle 9 can be detected.

The RAM 95 stores mounting data on component mounting, such as position data of X and Y directions (indicated by X and Y respectively) and an angle (indicated by Z) in the printed board, alignment numbers of the component feeding units 13 (indicated by FDR), and so on, in a mounting order. Furthermore, the RAM 95 stores component disposition data, i.e. data of each type of the electronic components (component ID) corresponding to each alignment number of the component feeding units 13. Furthermore, the RAM 95 stores component library data having component feature data, as described below.

An ON or OFF output of the line sensor unit 96 is performed at each of the CCD elements. A border between a shaded portion and an illuminated portion is calculated as a peak value of a lower end position by the CPU 93. The RAM 95 includes a bring-in memory to store a lower end position every time it is measured and a hold memory to store the lowest measured end position during an operation. The bring-in memory stores values of lower end levels of the suction nozzle 9 (or the electronic component A) calculated at intervals of predetermined moving distances, i.e., at intervals of predetermined time from one outputs of the line sensor unit 96. The hold memory stores the largest value during an operation, i.e., every time a newly measured value of the lower end position which is stored in the bring-in memory is larger (lower) than that stored in the hold memory, the new value replaces the value stored in the hold memory.

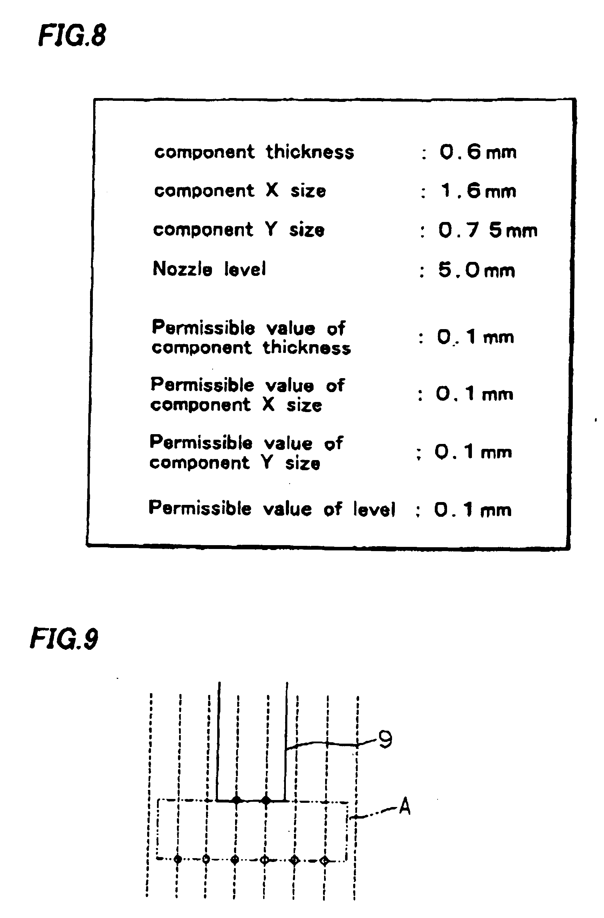

Furthermore, the RAM 95 has component library data on component size etc. as shown in Fig. 8, the data being classified into component types. For example, data on a lower end level of the suction nozzle 9 is stored in the RAM 95, as a standard for comparing with a value of a detected lowest end level stored in the hold memory.

A select and switch station at a second position from the first measuring station IV is provided with a nozzle selecting and switching device 102 for selecting and switching to the suction nozzle 9 to be used for a next component picking-up operation after a mounting operation on the printed board B. At this select and switch station, the nozzle selecting and switching device 102 raises the suction nozzle 9 which completes mounting, and lowers the suction nozzle 9 to be used next from the mounting head 8.

An operation under the above-described structure will be described hereafter. First, when power is applied to the electronic component mounting apparatus 1, the CRT 92 displays an initial screen. An operator touches a "manufacturing running" operation switch enclosed by double boxes on the screen and then touches a start key. Then, automatic running of a mounting operation of a chip component A starts.

When a printed board B is conveyed and mounted on the XY table 52 by a mounting device (not shown), the CPU 93 drives a linear motor 14 to have the predetermined component feeding unit 13 on the slide base 12 move to a component picking-up position by the suction nozzle 9 according to the mounting data (NC data) corresponding to the target printed board B stored in the RAM 95.

During this operation, the rotation table 7 intermittently rotates to move the mounting head 8 to the pickup station I, and the suction nozzle 9 already selected by the nozzle selecting and switching device is positioned above the component picking-up position. The roller attached body 54 moves along the cylindrical cam with the movement of the mounting head 8, and the cam followers 55 and 56 which interpose the cylindrical cam therebetween shift to a position where the cam followers 55 and 56 can interpose the protrusion 67 of the vertical shift block 63 therebetween.

During the movement of the mounting head 8, a cam (not shown) rotates by rotation of the index motor 101 so that the vertical shift bar descends to push a turn lever (not shown) of the component feeding unit 13 down. Then, the tape wound around the tape reel 16 is forwarded by a predetermined pitch, and the cover tape reel 15 rotates to peel the cover tape off the tape.

The CPU 93 rotates the stroke motor 115 through the interface 90, moves the stroke adjustable plate 113 along the guide 118 through the ball screw 116 and the nut 117, and moves the moving body 66 along the rail 110 through the vertical guide piece 114 and the rollers 112. Accordingly, the cam follower 127 provided on the moving body 66 is positioned at a position where a descending stroke of calculated amount can be generated.

The cam 119 rotates by rotation of the index motor 101 to push the cam follower 122, turn the cam lever 121, and then the link lever 123, so that the vertical turning lever 124 turns downward around the axis 125. Then, by pulling force of the pulling spring 128, the rollers 112 rotate along the vertical guide piece 114 and the moving body 66 and the rail 110 descend so that the vertical shift board 65 integrally attached to the rail 110 descends along the guide 64. Accordingly, the vertical shift block 63 already interposed between the cam followers 55 and 56 descends to lower the roller attached body 54, so that the suction nozzle 9 descends to an upper surface of the chip component A and picks the component A up by suction. Then, the cam 119 further rotates to turn the turning lever 124 counterclockwise in Fig. 3 so that the suction nozzle 9 rises up to an original position with the component A attached thereto.

Next, the rotation table 7 intermittently rotates so that the cam followers 55 and 56 rotate along the cylindrical cam, thereby moving the mounting head 8 holding the component A toward a next station.

The rotation table 7 intermittently rotates further so that the mounting head 8 reaches the component recognition station II. At the component recognition station II, the component recognition camera 88 takes an image of the lower surface of the component A and the recognition processing device 89 performs recognition processing of the taken image so that a shift amount of the component A attached to the suction nozzle 9 from a proper position is recognized.

The mounting head 8 moves to an angle adjustment station, and a head rotation device rotates the mounting head 8 by a rotation angle calculated by adding an original angle data and an angle to be corrected based on a recognition result by the component recognition device 89.

Next, the mounting head 8 reaches the mounting station III by intermittent rotation of the rotation table 7. During this intermittent rotation of the rotation table 7, the CPU 93 calculates an amount of a descending stroke, and rotates the stroke motor 115 to adjust the position of the moving body 66 in order to make a descending stroke of calculated amount, in a manner similar to the case in the pickup station I. Accordingly, the mounting head 8 descends in a manner similar to the case in the pickup station I, and the component A picked up by the suction nozzle 9 is mounted on the printed board B mounted on the XY table 52 which is positioned by moving by an amount to be corrected by rotation of the X axis drive motor 50 and the Y axis drive motor 51, the amount to be corrected being calculated out based on the recognition result of the component recognition processing device 89.

At the first measuring station IV at a second position from the mounting station III, the line sensor unit 96 detects a lower end level of the suction nozzle 9 after the component mounting operation. First, when the CPU 93 detects a timing of a start of detection, that is, a little before the mounting head 8 stops at the station, the floodlight 97 emits light beams and the line sensor unit 96 starts outputting. At this timing, data for a previous component in the bring-in memory and the hold memory are cleared, and the CPU 93 calculates a border between the shaded portion and the illuminated portion as the vertical position of the lower end of the suction nozzle using outputs of the line sensor unit 96 and stores the value in the bring-in memory. The origin for measuring the value of the vertical position of the lower end is set above any of possible lower end position of the suction nozzle. Thus, the lower the vertical position of the lower end of the suction nozzle is, the larger the measured value becomes.

The CPU 93 compares the value of the lower end in the bring-in memory with a value in the hold memory which is "0" at first. The suction nozzle 9 keeps moving during this process and the CPU 93 repeats the same measuring process until a timing of terminating of the detection. Normally, the suction nozzle 9 does not hold the electronic component A after completing a mounting operation of the electronic component A on the printed board B. When the suction nozzle 9 comes to a position shown in a fourth vertical dotted line from a left side of Fig. 9 where light beams emitted by the floodlight 97 of the line sensor unit 96 are applied, the CPU 93 reads outputs of the line sensor unit 96, calculates a value of a lower end position shown by a filled circle on the dotted line of Fig. 9, stores the value of the lower end position in the bring-in memory, and compares that value with the value in the hold memory. Since the value in the bring-in memory is larger than that in the hold memory, the value in the bring-in memory is written in the hold memory. Note that Fig. 9 also shows an electronic component, denoted by the dotted line, which is inadvertently held by the suction nozzle after a completion of a mounting cycle.

The suction nozzle 9 keeps moving during this process, and the CPU 93 reads outputs of the line sensor unit 96 on a fifth vertical dotted line from a left side of Fig. 9 next time, and calculates a value of a lower end position shown by a filled circle on the line, and stores the value in the bring-in memory. If that value in the bring-in memory is larger than the value written in the hold memory, the value written in the hold memory is updated to the value stored in the bring-in memory. When the CPU 93 completes reading of outputs by the line sensor unit 96 on each of vertical dotted lines of Fig. 9 accordingly and detects a timing of terminating of the detection, the CPU 93 stops reading and compares the value written in the hold memory, for example, 4.95 mm with the lower end level of the suction nozzle 9, for example, 5.00 mm stored in the RAM 95 for comparison, in a case of a component type shown in Fig. 8. Since a difference of the values, i.e., 0.05 mm is within a range of permissible values of the nozzle level (between plus and minus 0.1 mm), the suction nozzle 9 is not worn beyond a limit. Therefore, the CPU 93 does not inform (warn) the operator of wearing, but stores the difference value of 0.05 mm in the RAM 95. In this case, when the difference value is out of the range of the permissible values (between plus and minus 0.1 mm), the CPU 93 informs the operator that the suction nozzle 9 is worn by an informing device (not shown). However, there is a case where the suction nozzle 9 itself is not attached to the mounting head 8, i.e. missing. Furthermore, when a value of a lower end level stored in the bring-in memory is too large, there may be a case where the suction nozzle 9 is about to fall from the mounting head 8. In those cases, the CPU 93 controls and stops the electronic component mounting apparatus 1.

At the select and switch station, the nozzle selecting and switching device 102 replaces the suction nozzle 9 used for the current mounting with the suction nozzle 9 for a next mounting operation. When the selecting and switching device 102 selects the suction nozzle 9 which is already in use and has its lower end position measured, the CPU 93 calculates an amount of a descending stroke of the suction nozzle 9 at the pickup station I and the mounting station III, corresponding to the above-described difference value of 0.05 mm read out from the RAM 95, and rotates the stroke motor 115 to move the moving body 66 to a position where the suction nozzle 9 can descend by the amount. Accordingly, even if the suction nozzle 9 is worn with time or changes its lower end level by thermal expansion, the electronic component A can be picked up and mounted properly by controlling a descending amount of the suction nozzle 9, corresponding to changes in the suction nozzle 9.

However, there also occurs a case where the suction nozzle 9 keeps holding the electronic component A even after completing the mounting operation of the electronic component A. In this case, the CPU 93 reads outputs of the line sensor unit 96 when the suction nozzle 9 and the electronic component A come to a position shown by a second vertical dotted line from a left side of Fig. 9 where light beams emitted by the floodlight 97 of the line sensor unit 96 are applied. Then, the CPU 93 calculates a value of a lower end position shown by an open circle on the dotted line of Fig. 9, stores the value in the bring-in memory, and compares the value with the value in the hold memory. Since the value in the bring-in memory is larger than the value in the hold memory, the value in the bring-in memory is written in the hold memory. The suction nozzle 9 keeps moving during this process, and the CPU 93 reads outputs of the line sensor unit 96 at a position shown by a third dotted vertical line from the left side of Fig. 9, calculates a value of a lower end position shown by an open circle on the dotted line of Fig. 9, and stores the value in the bring-in memory. Since the value in the bring-in memory is larger than the value written in the hold memory, the value written in the hold memory is updated to the value in the bring-in memory.

When the CPU 93 completes reading of outputs by the line sensor unit 96 on each of dotted vertical lines of Fig. 9 accordingly and detects a timing of terminating of the detection, the CPU 93 stops reading and compares the value stored in the hold memory, for example, 5.55 mm with the lower end level of the suction nozzle 9, 5.00 mm, stored in the RAM 95 for comparison, in a case of a component type shown in Fig. 8. Since a difference of the values, i.e., 0.55 mm is out of a range of permissible values (between plus and minus 0.1 mm) of the nozzle level, the CPU 93 decides that the suction nozzle 9 keeps holding the electronic component A. Therefore, the CPU 93 makes the suction nozzle 9 discharge the electronic component A in an exhaust box disposed at a predetermined station between the first measuring station IV and the pickup station I, for example. When the CPU 93 decides that the suction nozzle 9 holds the electronic component A, the CPU 93 can stop the electronic component apparatus 1 or inform the operator of that by an informing device (visual or audio), alternatively.

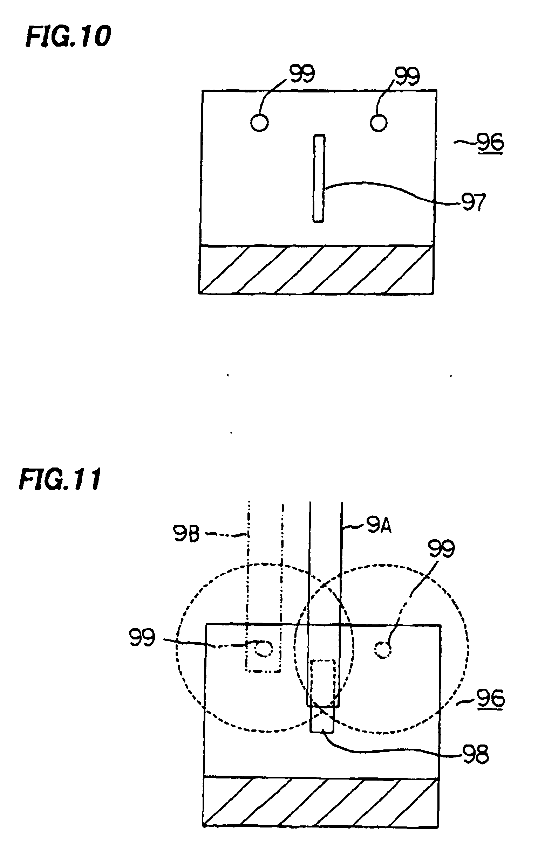

Next, an electronic component mounting apparatus of a second embodiment of the invention will be described with reference to Figs. 1, 10, and 11. A second measuring station is provided at a next position of the select and switch station, being disposed with the line sensor unit 96, which is formed into a horseshoe shape at its cross section, as a level detection sensor for measuring a lower end level of the suction nozzle 9 in a manner similar to the case in the first measuring station IV. As described above, the line sensor unit 96 includes the floodlight 97 (on one side wall) for emitting light beams in a horizontal direction, and the light receiving device 98 (on another facing side wall) for receiving the emitted light beams, which is formed of many CCD elements linearly aligned in a perpendicular direction. Furthermore, in addition to the floodlight 97, floodlights 99 formed of LEDs (light emitting diodes) are disposed on both sides of the floodlight 97 on a side wall of the line sensor unit 96. Two large circles shown in Fig. 11 show ranges covered by the floodlights 99.

At the select and switch station, the nozzle selecting and switching device 102 selects the suction nozzle 9 to be used for a next electronic component picking-up operation, the suction nozzle 9 used in the current mounting operation is released, and the suction nozzle 9 to be used for the next mounting operation is attached to the mounting head.

At the second measuring station, a lower end level of the selected and switched suction nozzle 9 is measured by the line sensor unit 96 as described above. At the pickup station I and the mounting station III, the CPU 93 calculates a descending amount of the suction nozzle 9, and rotates the stroke motor 115 to move the moving body 66 to a position where the suction nozzle 9 can descend by the amount. Accordingly, even if the suction nozzle 9 is worn with time or changes at its lower end level by thermal expansion, the electronic component A can be picked up and mounted properly by controlling a descending amount of the suction nozzle 9, corresponding changes in the suction nozzle 9. In this case, when a difference between the value of the lower end level in the hold memory and the value stored in the RAM 95 is out of the range of the permissible values, the CPU 93 informs the operator that the suction nozzle 9 is worn by an informing device (not shown). However, there is a case where the suction nozzle 9 itself is not mounted on the mounting head 8, i.e. missing. Furthermore, when a value of a lower end level stored in the hold memory is too large, there can be a case where the suction nozzle 9 is about to fall from the mounting head 8. In those cases, the CPU 93 controls and stops the electronic component mounting apparatus 1.

At the second measuring station, suction nozzles 9B, except for a suction nozzle 9A which is selected by the nozzle selecting and switching device 102 for a next picking-up operation, may not be raised at all or high enough before it descends into the line sensor unit 96 for the lower end detection. If this happens, the design of the mounting head dictates that the nozzles 9B are bound to fall. When the nozzles 9B are not raised high enough, lights from the floodlights 99 are partially shaded by the suction nozzle 9B so that an amount of lights received at the light receiving device 98 from the floodlights 97 and 99 becomes smaller. In this case, the CPU 93 decides that the suction nozzles 9B except for the suction nozzle 9A are about to fall so that the CPU 93 stops the electronic component mounting apparatus 1 or informs the operator of that by an informing device (visual or audio), as appropriate.

In the second embodiment, although the floodlights 99 are provided in the line sensor unit 96 at the second measuring station, the floodlights 99 can be provided in the line sensor unit 96 at the first measuring station described in the first embodiment. This enables detecting of presence or absence of the suction nozzles 9, except for the suction nozzle 9 used for component mounting, and detecting of the suction nozzles which is about to fall.

The invention is not limited to the above-described electronic component mounting apparatus of high-speed type, but can be applied to an electronic component mounting apparatus where electronic component feeding devices does not move but mounting heads move in a plane direction.

Although particular preferred embodiments of the invention have been disclosed in detail, it will be recognized that variations or modifications of the disclosed apparatus, including the rearrangement of parts, are possible and lie within the scope of the invention as defined by the accompanying claims.

## Claims

1. An electronic component mounting apparatus comprising:
- a component feeding unit (13) feeding an electronic component (A);
- a suction nozzle (9) picking up the electronic component (A) from the component feeding unit and mounting the electronic component (A) on a printed board (B); and
- a sensor detecting a vertical position of a lower end of the suction nozzle (9) after the suction nozzle (9) releases the electronic component (A) to the printed board (B),
**characterized in that**
the sensor is a position sensor (96) for measuring the vertical position of the lower end of the suction nozzle (9), and further comprising a decision device (93) judging that the suction nozzle (9) is missing when the vertical position of the lower end of the suction nozzle (9) measured by the position sensor (96) is higher than a predetermined position.

2. The electronic component mounting apparatus of claim 1, further comprising a drive source moving the suction nozzle (9) vertically and a control device determining a range of a vertical movement of the suction nozzle (9) based on the vertical position of the lower end of the suction nozzle (9) measured by the position sensor (96).

3. The electronic component mounting apparatus of claim 1 or 2, wherein the decision device (93) is further configured for judging that the suction nozzle (9) holds the electronic component (A) when the vertical position of the lower end of the suction nozzle (9) measured by the position sensor (96) is lower than a predetermined position.

4. The electronic component mounting apparatus according to any of claims 1 to 3, wherein the decision device (93) is further configured for judging that the suction nozzle (9) is about to fall when the vertical position of the lower end of the suction nozzle (9) measured by the position sensor (96) is lower than a predetermined position.

5. The electronic component mounting apparatus according to any of claims 1 to 4, wherein the position sensor (96) comprises a line sensor.

6. The electronic component mounting apparatus of claim 1 further comprising:
- a plurality of component feeding units (13) feeding electronic components;
- a plurality of suction nozzles (9) that are provided on a mounting head (8);
- a line sensor unit as the position sensor (96) comprising a first light source (97) and a light receiving device (98);
- a second light source (99) provided in the line sensor unit (96) in addition to the first light source (97); and
- a decision device (93) judging that a suction nozzle (9) is about to fall when an amount of light received by the light receiving device (98) from the first and second light sources (97, 99) is below a predetermined amount.

7. The electronic component mounting apparatus of claim 6, wherein the decision device (93) is configured to except from judging the suction nozzles (9A) that are mounted on the mounting head (8) and have mounted at least one electric component (A) on the printed board (B).

8. The electronic component mounting apparatus of claim 6 or 7, further comprising a nozzle select and switch device (102) replacing a suction nozzle (9) used in a first mounting operation with a suction nozzle (9A) selected for a second mounting operation, wherein the decision device (93) is configured to except from judging the suction nozzles (9, 9A) that are selected by the nozzle selection and switch device (102) and mounted on the mounting head (8).

## Patentansprüche

1. Vorrichtung zur Montage von elektronischen Bauteilen, mit:
- einer Bauteilzuführeinheit (13), die ein elektronisches Bauteil (A) zuführt;
- einer Saugdüse (9), die das elektronische Bauteil (A) von der Bauteilzuführeinheit aufnimmt und das elektronische Bauteil (A) auf einer Leiterplatte (B) montiert; und
- einem Sensor, der eine Vertikalposition eines unteren Endes der Saugdüse (9) erfasst, nachdem die Saugdüse (9) das elektronische Bauteil (A) der Leiterplatte (B) freigibt,
**dadurch gekennzeichnet, dass**
der Sensor ein Positionssensor (96) zur Messung der Vertikalposition des unteren Endes der Saugdüse (9) ist, und weiterhin mit einer Entscheidungseinrichtung (93), die entscheidet, dass die Saugdüse (9) fehlt, wenn der Positionssensor (96) misst, dass die Vertikalposition des unteren Endes der Saugdüse (9) höher liegt als eine vorbestimmte Position.

2. Vorrichtung zur Montage von elektronischen Bauteilen nach Anspruch 1, weiterhin mit einer Ansteuerungsquelle, die die Saugdüse (9) vertikal bewegt, und einer Steuereinrichtung, die aufgrund der Vertikalposition des unteren Endes der Saugdüse (9), die vom Positionssensor (96) gemessen wird, einen Bereich einer Vertikalbewegung der Saugdüse (9) bestimmt.

3. Vorrichtung zur Montage von elektronischen Bauteilen nach Anspruch 1 oder 2, in der die Entscheidungseinrichtung (93) weiterhin dazu ausgelegt ist zu entscheiden, dass die Saugdüse (9) das elektronische Bauteil (A) hält, wenn die Vertikalposition des unteren Endes der Saugdüse (9), die vom Positionssensor (96) gemessen wird, niedriger liegt als eine vorbestimmte Position.

4. Vorrichtung zur Montage von elektronischen Bauteilen nach einem der Ansprüche 1 bis 3, in der die Entscheidungseinrichtung (93) weiterhin dazu ausgelegt ist zu entscheiden, dass die Saugdüse (9) kurz davor ist, zu fallen, wenn die Vertikalposition des unteren Endes der Saugdüse (9), die vom Positionssensor (96) gemessen wird, niedriger liegt als eine vorbestimmte Position.

5. Vorrichtung zur Montage von elektronischen Bauteilen nach einem der Ansprüche 1 bis 4, in der der Positionssensor (96) einen Liniensensor umfasst.

6. Vorrichtung zur Montage von elektronischen Bauteilen nach Anspruch 1, weiterhin mit:
- mehreren Bauteilzuführeinheiten (13), die elektronische Bauteile zuführen;
- mehreren Saugdüsen (9), die auf einem Montierkopf (8) vorgesehen sind;
- einer Liniensensoreinheit als Positionssensor (96), die eine erste Lichtquelle (97) und eine Lichtempfangseinrichtung (98) umfasst;
- einer zweiten Lichtquelle (99), die zusätzlich zur ersten Lichtquelle (97) in der Liniensensoreinheit (96) vorgesehen ist; und
- einer Entscheidungseinrichtung (93), die entscheidet, dass eine Saugdüse (9) kurz davor ist, zu fallen, wenn die Lichtempfangseinrichtung (98) von der ersten und zweiten Lichtquelle (97, 99) eine Lichtmenge empfängt, die unter einer vorbestimmten Menge liegt.

7. Vorrichtung zur Montage von elektronischen Bauteilen nach Anspruch 6, in der die Entscheidungseinrichtung (93) ausgelegt ist, die Saugdüsen (9A) bei der Entscheidung auszulassen, die auf dem Montierkopf (8) montiert sind und mindestens ein elektrisches Bauteil (A) auf der Leiterplatte (B) montiert haben.

8. Vorrichtung zur Montage von elektronischen Bauteilen nach Anspruch 6 oder 7, weiterhin mit einer Düsenauswahl- und -umschalteinrichtung (102), die eine bei einem ersten Montiervorgang verwendete Saugdüse (9) gegen eine Saugdüse (9A) austauscht, die für einen zweiten Montiervorgang ausgewählt wurde, wobei die Entscheidungseinrichtung (93) so ausgelegt ist, die. Saugdüsen (9, 9A) bei der Entscheidung auszulassen, die von der Düsenauswahl- und -umschalteinrichtung (102) ausgewählt sind und auf dem Montierkopf (8) montiert sind.

## Revendications

1. Appareil de montage de composant électronique comprenant :
- une unité d'alimentation en composant (13) fournissant un composant électronique (A) ;
- une buse d'aspiration (9) attrapant le composant électronique (A) depuis l'unité d'alimentation en composant et montant le composant électronique (A) sur une carte de circuit imprimé (B) ; et
- un capteur détectant une position verticale d'une extrémité inférieure de la buse d'aspiration (9) après que la buse d'aspiration (9) ait libéré le composant électronique (A) sur la carte de circuit imprimé (B),
**caractérisé en ce que**
le capteur est un capteur de position (96) destiné à mesurer la position verticale de l'extrémité inférieure de la buse d'aspiration (9), et comprenant en outre un dispositif de décision (93) jugeant que la buse d'aspiration (9) manque lorsque la position verticale de l'extrémité inférieure de la buse d'aspiration (9) mesurée par le capteur de position (96) est supérieure à une position prédéterminée.

2. Appareil de montage de composant électronique selon la revendication 1, comprenant en outre une source d'énergie déplaçant la buse d'aspiration (9) verticalement et un dispositif de commande déterminant une étendue de mouvement vertical de la buse d'aspiration (9) sur la base de la position verticale de l'extrémité inférieure de la buse d'aspiration (9) mesurée par le capteur de position (96).

3. Appareil de montage de composant électronique selon la revendication 1 ou 2, dans lequel le dispositif de décision (93) est en outre configuré afin de juger que la buse d'aspiration (9) maintient le composant électronique (A) lorsque la position verticale de l'extrémité inférieure de la buse d'aspiration (9) mesurée par le capteur de position (96) est inférieure à une position prédéterminée.

4. Appareil de montage de composant électronique selon l'une quelconque des revendications 1 à 3, dans lequel le dispositif de décision (93) est en outre configuré afin de juger que la buse d'aspiration (9) est sur le point de tomber lorsque la position verticale de l'extrémité inférieure de la buse d'aspiration (9) mesurée par le capteur de position (96) est inférieure à une position prédéterminée.

5. Appareil de montage de composant électronique selon l'une quelconque des revendications 1 à 4, dans lequel le capteur de position (96) comprend un capteur de ligne.

6. Appareil de montage de composant électronique selon la revendication 1, comprenant en outre :
- une pluralité d'unités d'alimentation en composants (13) fournissant des composants électroniques ;
- une pluralité de buses d'aspiration (9) qui sont prévues sur une tête de montage (8) ;
- une unité de capteur de ligne en tant que capteur de position (96) comprenant une première source de lumière (97) et un dispositif de réception de la lumière (98) ;
- une seconde source de lumière (99) prévue dans l'unité de capteur de ligne (96) en plus de la première source de lumière (97) ; et
- un dispositif de décision (93) jugeant qu'une buse d'aspiration (9) est sur le point de tomber lorsqu'une quantité de lumière reçue par le dispositif de réception de la lumière (98) de la part de la première et de la seconde sources de lumière (97, 99) est inférieure à une quantité prédéterminée.

7. Appareil de montage de composant électronique selon la revendication 6, dans lequel le dispositif de décision (93) est configuré afin de ne pas juger les buses d'aspiration (9A) qui sont montées sur la tête de montage (8) et qui ont monté au moins un composant électronique (A) sur la carte de circuit imprimé (B).

8. Appareil de montage de composant électronique selon la revendication 6 ou 7, comprenant en outre un dispositif de sélection et d'activation de buse (102) remplaçant une buse d'aspiration (9) utilisée lors d'une première opération de montage par une buse d'aspiration (9A) sélectionnée pour une seconde opération de montage, dans lequel le dispositif de décision (93) est configuré afin de ne pas juger les buses d'aspiration (9, 9A) qui sont sélectionnées par le dispositif de sélection et d'activation de buses (102) et qui sont montées sur la tête de montage (8).
